# EUROPEAN PATENT SPECIFICATION

(11) **EP 4 390 805 B1**
(45) Date of publication and mention of the grant of the patent: **31.12.2025**
(21) Application number: 24150118.8
(22) Date of filing: 11.11.2019
(51) Int. Cl.: G06Q 10/08

(54) **COMPUTER SYSTEM AND METHOD FOR NAVIGATING BUILDING INFORMATION MODEL VIEWS**
COMPUTERSYSTEM UND VERFAHREN ZUR NAVIGATION DURCH GEBÄUDEINFORMATIONSMODELLANSICHTEN
SYSTÈME INFORMATIQUE ET PROCÉDÉ DE NAVIGATION DANS DES VUES DE MODÈLES D'INFORMATIONS DE CONSTRUCTION

(30) Priority: 13.11.2018 US 201862760904 P; 07.11.2019 US 201916677081
(43) Date of publication of application: 26.06.2024
(62) Divisional of application: 19885797.1
(73) Proprietor: Procore Technologies, Inc., Carpinteria CA 93013 (US)
(72) Inventor: BINDLOSS, Chris, Carpinteria, 93013 (US); MCCOOL, Dave, Carpinteria, 93013 (US)
(74) Representative: EIP

(56) References cited:
- US-A1- 2009 226 080
- US-B1- 6 346 938

## Description

### CROSS-REFERENCE TO RELATED APPLICATION

This application claims priority to U.S. provisional application No. 62/760,904, filed on November 13, 2018 and titled "Managing Coordination Issues and Navigating Building Information Models," and to U.S. non-provisional application No. 16/677,081, filed on November 7, 2019 and titled "Computer System and Method for Navigating Building Information Model Views.

### BACKGROUND

Construction projects are often complex endeavors involving the coordination of many professionals across several discrete phases. Typically, a construction project commences with a design phase, where architects design the overall shape and layout of a construction project, such as a building. Next, engineers step in during a planning phase where they take the architects' designs and produce engineering drawings and plans for the construction of the project. At this stage, engineers may also design various portions of the project's infrastructure, such as HVAC, plumbing, electrical, etc., and produce plans reflecting these designs as well. After, or perhaps in conjunction with, the planning phase, contractors may step in during a logistics phase to review these plans and begin to allocate various resources to the project, including determining what materials to purchase, scheduling delivery, and developing a plan for carrying out the actual construction of the project. Finally, during the construction phase, construction professionals begin to construct the project based on the finalized plans.

### OVERVIEW

As a general matter, one phase of a construction project involves the creation, review, and sometimes revision, of plans of the construction project. In most cases, these plans comprise visual representations of the construction project that visually communicate information about the construction project, such as how to assemble or construct the project. Such visual representations tend to take one of at least two different forms. One form may be a two-dimensional technical drawing, such as an architectural drawing or a construction blueprint, in which two-dimensional line segments of the drawing represent certain physical elements of the construction project like walls and ducts. In this respect, a two-dimensional technical drawing could be embodied either in paper form or in a computerized form, such as an image file (e.g., a PDF, JPEG, etc.).

To advance over two-dimensional technical drawings, computerized, three-dimensional technology was developed as another form in which information about a construction project can be visually communicated. In this respect, a three-dimensional model of the construction project is typically embodied in a computerized form, such as in a building information model (BIM) file, with three-dimensional meshes visually representing the physical elements of the construction project (e.g., walls, ducts, etc.). Correspondingly, specialized software has been developed that is capable of accessing a BIM file and, based on this BIM file, rendering a three-dimensional view of the construction project from one or more perspectives.

Such software tools that render these three-dimensional views typically provide an ability to adjust the perspective at which the three-dimensional view is presented. For instance, one way a software tool may do this is by repositioning the perspective either forward or backward along an x-axis of the model in response to receiving a first type of user input via a peripheral, such as pressing the up arrow or down arrow on a keyboard or a click and drag with a mouse. The software tool may reposition the perspective laterally along a y-axis of the model in response to receiving a second type of user input via a peripheral, such as pressing the left arrow or right arrow on a keyboard or a different type of click and drag with a mouse. The software tool may reposition the perspective either up or down along a z-axis of the model in response to receiving a third type of user input via a peripheral, such as pressing a combination of keys on a keyboard (e.g., the Control key and the up arrow, or the Control key and the down arrow) or yet a different type of click and drag with a mouse. The software tool may reposition the orientation of the perspective in response to receiving a fourth type of user input via a peripheral, such as pressing a combination of keys on a keyboard (e.g., the Alt key and the up arrow, or the Control key and the down arrow) or yet a different type of click and drag with a mouse.

However, these approaches suffer from several drawbacks. For instance, in some cases, the software tool may only reposition the perspective so long as the user input is ongoing. And as screen real estate tends to be limited, a user may have to engage in repeated user inputs (e.g., repeated clicks and drags or repeated swipes) in order to reposition the perspective a relatively long distance, which tends to be more prone to user error and may thus result in a poor user experience. Additionally, in some cases, the software tool may only reposition the perspective in the direction of the perspective's orientation. Thus, repositioning the perspective in a direction other than the direction of the current perspective (e.g., repositioning directly along the z-axis only (i.e., straight up, vertically) or repositioning directly along one of the lateral axes only may require multiple user inputs (e.g., a first user input to re-orient the perspective in the desired direction, a second user input to reposition the perspective, and a third user input to re-orient the perspective back to a desired perspective). The number of user inputs required to reposition the perspective in the desired manner and to a desired location may be unexpectedly high and may thus too result in a poor user experience.

To address these problems (among others), disclosed herein is software technology that facilitates improved navigation of a three-dimensional BIM view. In one aspect, disclosed herein is a BIM viewer tool that may facilitate navigation of the three-dimensional BIM view by adjusting the perspective along either or both of the lateral axes. In another aspect, the disclosed BIM viewer tool may facilitate navigation of the three-dimensional BIM view by adjusting the perspective directly along the vertical axis. And in yet another aspect, the disclosed BIM viewer tool may facilitate navigation of the three-dimensional BIM view by adjusting the orientation of the perspective along the two lateral axes and the vertical axis.

To facilitate these types of navigation, the BIM viewer tool may generate a GUI that presents the three-dimensional BIM view as well as one or more navigational controls overlaid on the three-dimensional BIM view. The BIM viewer tool may also be configured to receive a user input at the navigational controls (e.g., a touch, or a touch combined with a drag), and, based on a respective user input, change the position of the perspective from which the BIM viewer tool renders the three-dimensional BIM view.

In some embodiments, these navigational controls may take the form of one or more of (1) a "Walk" navigational control through which a user may provide a user input in order to reposition the perspective of the three-dimensional BIM view in any direction laterally and at variable speed regardless of the current perspective's orientation, (2) an "Up/Down" navigational control through which a user may provide a user input in order to reposition the perspective of the three-dimensional BIM view up or down along the vertical Z-axis and at variable speed regardless of the current perspective's orientation, (3) a "Look" navigational control through which a user may provide a user input in order to reposition the orientation of the perspective of the three-dimensional BIM view in any direction laterally and at variable speed regardless of the current perspective's orientation, (4) a two-dimensional inset control through which a user may immediately relocate the perspective to any position within the construction project and at any orientation, and (5) an "elevation control" control through which a user may provide a user input in order to reposition the perspective of the three-dimensional BIM view to a preset position along the vertical Z-axis to provide a view of a particular floor of the construction project, among combinations of the forgoing navigational controls as well as other possibilities.

Accordingly, in one aspect, disclosed herein is a computer-implemented method that involves (a) rendering via a graphical user interface (GUI) a three-dimensional view of a construction project using a three-dimensional model file that defines a set of meshes, wherein the GUI includes first, second, and third navigational controls and the three-dimensional view of the construction project has a perspective from which the view is presented, (b) based on respective user inputs received via the first, second, and third navigational controls, receiving respective indications, each including at least a respective direction component, (c) and responsive to receiving a given respective indication, repositioning the perspective from which the three-dimensional view of the construction project is generated based on the respective direction component included in the given respective indication.

In another aspect, disclosed herein is a computing system that comprises at least one processor, a non-transitory computer-readable medium, and program instructions stored on the non-transitory computer-readable medium that are executable by the at least one processor to cause the computing system to carry out the operations disclosed herein, including but not limited to the operations of the foregoing method.

In yet another aspect, disclosed herein is a non-transitory computer-readable medium comprising program instructions that are executable to cause a computing system to carry out the operations disclosed herein, including but not limited to the operations of the foregoing method.

One of ordinary skill in the art will appreciate these as well as numerous other aspects in reading the following disclosure. US 6 346 938 B1 refers to an image processing system which renders, displays and provides virtual user navigation through multiple size and aspect views of a three-dimensional (3D) geometric model of an object, such as an urban scene. US 2009/226080 A1 refers a three dimensional (3D) media editing application for dynamically presenting different views of a 3D project that includes one or more objects disbursed throughout a 3D space.

### BRIEF DESCRIPTION OF THE DRAWINGS

FIG. 1 depicts an example network configuration in which example embodiments may be implemented.
FIG. 2 depicts an example computing device that may be configured carry out one or more of the functions of the present disclosure.
FIG. 3 depicts an example output produced by a device executing one embodiment of a software tool according to the present disclosure.
FIG. 4 depicts an example output produced by a device executing one embodiment of a software tool according to the present disclosure.
FIG. 5 depicts an example flow diagram illustrating example functions for repositioning a perspective of a BIM view, according to one embodiment of the present disclosure.
FIG. 6 depicts an example output produced by a device executing one embodiment of a software tool according to the present disclosure.

### DETAILED DESCRIPTION

The following disclosure makes reference to the accompanying figures and several example embodiments. One of ordinary skill in the art should understand that such references are for the purpose of explanation only and are therefore not meant to be limiting. Part or all of the disclosed systems, devices, and methods may be rearranged, combined, added to, and/or removed in a variety of manners, each of which is contemplated herein.

### I. EXAMPLE SYSTEM CONFIGURATION

The present disclosure is generally directed to software technology for managing construction projects, and in particular to a software tool that facilitates (i) the identification of Coordination Issues in a construction project, and (ii) the synchronization of these Coordination Issues among multiple instances of the software tool for use by multiple construction professionals. As one possible implementation, this software technology may include both front-end software running on client stations that are accessible to individuals associated with construction projects (e.g., contractors, project managers, architects, engineers, designers, etc., each of which may be referred to generally herein as a "construction professional") and back-end software running on a back-end platform (sometimes referred to as a "cloud" platform) that interacts with and/or drives the front-end software, and which may be operated (either directly or indirectly) by the provider of the front-end client software. As another possible implementation, this software technology may include front-end client software that runs on client stations without interaction with a back-end platform. The software technology disclosed herein may take other forms as well.

In general, such front-end client software may enable one or more individuals responsible for a construction project to perform various tasks related to the management of the construction project, which may take various forms. According to some implementations, these tasks may include: rendering three-dimensional views of the construction project and navigating through the various three-dimensional views of the construction project in order to observe the construction project from various perspectives, as some non-limiting examples. Further, such front-end client software may take various forms, examples of which may include a native application (e.g., a mobile application) and/or a web application running on a client station, among other possibilities.

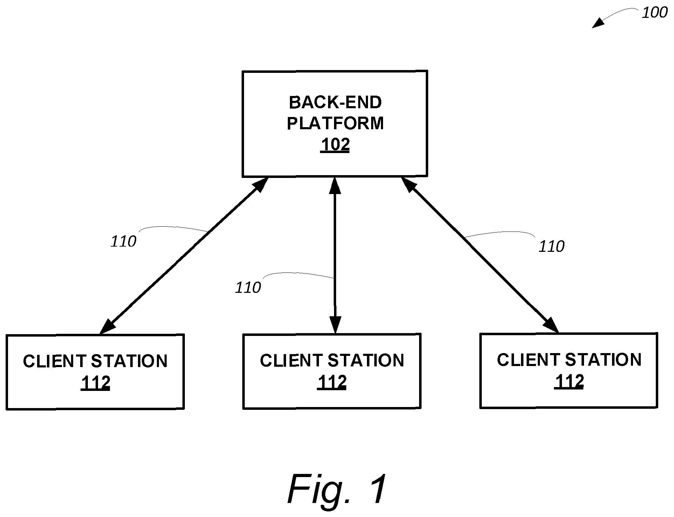

Turning now to the figures, FIG. 1 depicts an example network configuration 100 in which example embodiments of the present disclosure may be implemented. As shown in FIG. 1, network configuration 100 includes a back-end platform 102 that may be communicatively coupled to one or more client stations, depicted here, for the sake of discussion, as client stations 112.

Broadly speaking, back-end platform 102 may comprise one or more computing systems that have been provisioned with software for carrying out one or more of the functions disclosed herein, including but not limited to identifying Coordination Issues in a construction project, synchronizing these Coordination Issues among multiple instances of the software tool for use by multiple construction professionals, rendering three-dimensional views of models of a construction project, and/or transmitting data and/or instructions that cause one or more client stations 112 to output information related to a construction project, including the rendered views of the three-dimensional model of the construction project, and/or information related to the identified Coordination Issues. The one or more computing systems of back-end platform 102 may take various forms and be arranged in various manners.

For instance, as one possibility, back-end platform 102 may comprise computing infrastructure of a public, private, and/or hybrid cloud (e.g., computing and/or storage clusters) that has been provisioned with software for carrying out one or more of the functions disclosed herein. In this respect, the entity that owns and operates back-end platform 102 may either supply its own cloud infrastructure or may obtain the cloud infrastructure from a third-party provider of "on demand" computing resources, such include Amazon Web Services (AWS) or the like. As another possibility, back-end platform 102 may comprise one or more dedicated servers that have been provisioned with software for carrying out one or more of the functions disclosed herein. Other implementations of back-end platform 102 are possible as well.

In turn, client stations 112 may each be any computing device that is capable of running the front-end software disclosed herein. In this respect, client stations 112 may each include hardware components such as a processor, data storage, a user interface, and a network interface, among others, as well as software components that facilitate the client station's ability to run the front-end software disclosed herein (e.g., operating system software, web browser software, etc.). As representative examples, client stations 112 may each take the form of a desktop computer, a laptop, a netbook, a tablet, a smartphone, and/or a personal digital assistant (PDA), among other possibilities.

As further depicted in FIG. 1, back-end platform 102 is configured to interact with client stations 112 over respective communication paths 110. In this respect, each communication path 110 between back-end platform 102 and one of client stations 112 may generally comprise one or more communication networks and/or communications links, which may take any of various forms. For instance, each respective communication path 110 with back-end platform 102 may include any one or more of point-to-point links, Personal Area Networks (PANs), Local-Area Networks (LANs), Wide-Area Networks (WANs) such as the Internet or cellular networks, cloud networks, and/or operational technology (OT) networks, among other possibilities. Further, the communication networks and/or links that make up each respective communication path 110 with back-end platform 102 may be wireless, wired, or some combination thereof, and may carry data according to any of various different communication protocols. Although not shown, the respective communication paths 110 between client stations 112 and back-end platform 102 may also include one or more intermediate systems. For example, it is possible that back-end platform 102 may communicate with a given client station 112 via one or more intermediary systems, such as a host server (not shown). Many other configurations are also possible.

The interaction between client stations 112 and back-end platform 102 may take various forms. As one possibility, client stations 112 may send certain user input related to a construction project to back-end platform 102, which may in turn trigger back-end platform 102 to take one or more actions based on the user input. As another possibility, client stations 112 may send a request to back-end platform 102 for certain project-related data and/or a certain front-end software module, and client stations 112 may then receive project-related data (and perhaps related instructions) from back-end platform 102 in response to such a request. As yet another possibility, back-end platform 102 may be configured to "push" certain types of project-related data to client stations 112, such as rendered three-dimensional views, in which case client stations 112 may receive project-related data (and perhaps related instructions) from back-end platform 102 in this manner. As still another possibility, back-end platform 102 may be configured to make certain types of project-related data available via an API, a service, or the like, in which case client stations 112 may receive project-related data from back-end platform 102 by accessing such an API or subscribing to such a service. The interaction between client stations 112 and back-end platform 102 may take various other forms as well.

Although not shown in FIG. 1, back-end platform 102 may also be configured to receive data, such as data related to a construction project, from one or more external data sources, such as an external database and/or another back-end platform or platforms. Such data sources - and the data output by such data sources - may take various forms.

It should be understood that network configuration 100 is one example of a network configuration in which embodiments described herein may be implemented. Numerous other arrangements are possible and contemplated herein. For instance, other network configurations may include additional components not pictured and/or more or less of the pictured components.

### II. EXAMPLE COMPUTING DEVICE

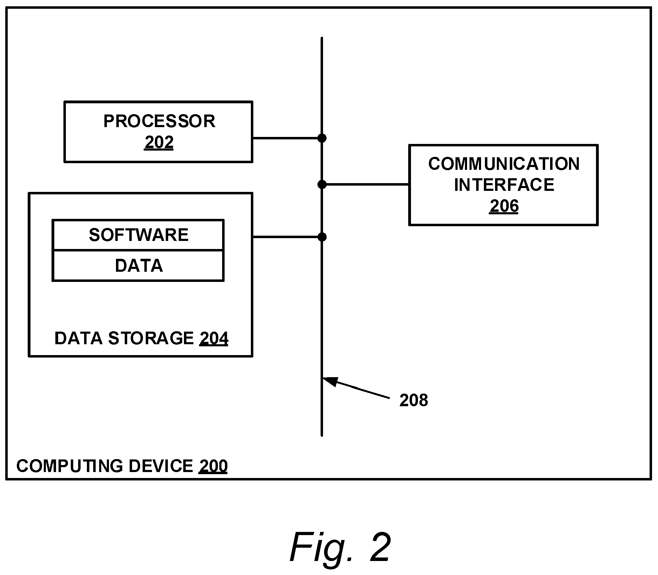

FIG. 2 is a simplified block diagram illustrating some structural components that may be included in an example computing device 200, which could serve as, for instance, the back-end platform 102 and/or one or more of client stations 112 in FIG. 1. In line with the discussion above, computing device 200 may generally include at least a processor 202, data storage 204, and a communication interface 206, all of which may be communicatively linked by a communication link 208 that may take the form of a system bus or some other connection mechanism.

Processor 202 may comprise one or more processor components, such as general-purpose processors (e.g., a single- or multi-core microprocessor), special-purpose processors (e.g., an application-specific integrated circuit or digital-signal processor), programmable logic devices (e.g., a field programmable gate array), controllers (e.g., microcontrollers), and/or any other processor components now known or later developed. In line with the discussion above, it should also be understood that processor 202 could comprise processing components that are distributed across a plurality of physical computing devices connected via a network, such as a computing cluster of a public, private, or hybrid cloud.

In turn, data storage 204 may comprise one or more non-transitory computer-readable storage mediums, examples of which may include volatile storage mediums such as randomaccess memory, registers, cache, etc. and non-volatile storage mediums such as read-only memory, a hard-disk drive, a solid-state drive, flash memory, an optical-storage device, etc. In line with the discussion above, it should also be understood that data storage 204 may comprise computer-readable storage mediums that are distributed across a plurality of physical computing devices connected via a network, such as a storage cluster of a public, private, or hybrid cloud.

As shown in FIG. 2, data storage 204 may be provisioned with software components that enable the computing device 200 to carry out the operations disclosed herein. These software components may generally take the form of program instructions that are executable by the processor 202 to carry out the disclosed functions, which may be arranged together into software applications, virtual machines, software development kits, toolsets, or the like, all of which are referred to herein as a software tool or software tools. Further, data storage 204 may be arranged to store project-related data in one or more databases, file systems, or the like. Data storage 204 may take other forms and/or store data in other manners as well.

Communication interface 206 may be configured to facilitate wireless and/or wired communication with configured other computing devices or systems, such as one or more client stations 112 when computing device 200 serves as back-end platform 102, or as back-end platform 102 when computing device 200 serves as one of client stations 112. As such, communication interface 206 may take any suitable form for carrying out these functions, examples of which may include an Ethernet interface, a serial bus interface (e.g., Firewire, USB 3.0, etc.), a chipset and antenna adapted to facilitate wireless communication, and/or any other interface that provides for wireless and/or wired communication. Communication interface 206 may also include multiple communication interfaces of different types. Other configurations are possible as well.

Although not shown, computing device 200 may additionally include one or more other interfaces that provide connectivity with external user-interface equipment (sometimes referred to as "peripherals"), such as a keyboard, a mouse or trackpad, a display screen, a touch-sensitive interface, a stylus, a virtual-reality headset, speakers, etc., which may allow for direct user interaction with computing device 200.

It should be understood that computing device 200 is one example of a computing device that may be used with the embodiments described herein. Numerous other arrangements are possible and contemplated herein. For instance, other computing devices may include additional components not pictured and/or more or fewer of the pictured components.

### III. EXAMPLE VISUAL REPRESENTATIONS OF CONSTRUCTION PROJECTS

As mentioned above, one aspect of managing a construction project involves the creation, review, and sometimes revision, of plans for the construction project. These plans assist construction professionals in carrying out the construction project. For example, some plans include written statements, such a punch list or submittal log, which may communicate, for instance, what materials are needed during construction. Other plans may include visual representations of the construction project that visually communicate to the construction professionals how to assemble or construct the project.

Depending on the type of construction project, these visual representations tend to take one of two different forms. As one possibility, these visual representations may take the form of a set of two-dimensional technical drawings, such as architectural drawings, engineering schematics, or construction blueprints, among others. From these two-dimensional technical drawings, the construction professionals can determine how to construct the project. As another possibility, these visual representations may take the form of a computerized, three-dimensional visual representation of the construction project. Construction professionals can use a corresponding software tool to review the three-dimensional visual representation, often in conjunction with a review of two-dimensional technical drawings, as an aid during the construction process.

In order to facilitate the creation and use of a computerized, three-dimensional model of the construction project, a team of architects, designers, and/or engineers may engage in a process referred to as Building Information Modeling. As a general matter, Building Information Modeling refers to the process of designing and maintaining a computerized representation of physical and functional characteristics of a construction project, such as a building. Specialized software tools can then access this computerized representation and process it to visually communicate how to construct the building via a navigable, three-dimensional model of the building and its infrastructure.

More specifically, but still by way of example, when architects, designers, and/or engineers engage in Building Information Modeling for a specific construction project, they generally produce what is referred to as a Building Information Model (BIM) file. In essence, a BIM file is a computerized description of the individual physical elements that comprise the construction project, such as the physical structure of the building, including walls, floors, and ceilings, as well as the building's infrastructure, including pipes, ducts, conduits, etc. This computerized description can include a vast amount of data describing the individual physical elements of the construction project and the relationships between these individual physical elements, including for instance, the relative size and shape of each element, and an indication of where each element will reside in relation to the other elements in the construction project.

BIM files can exist in one or more proprietary or open-source computer-file formats and are accessible by a range of specialized software tools. One type of specialized software tool that can access BIM files is referred to as a "BIM viewer." A BIM viewer is software that accesses the information contained within a BIM file or a combination of BIM files for a particular construction project and then, based on that file or those files, is configured to cause a computing device to render a three-dimensional view of the computerized representation of the construction project. This view is referred to herein as a "three-dimensional BIM view" or simply a "three-dimensional view."

In order for BIM viewer software to be able to cause a computing device to render a three-dimensional view of the construction project, BIM files typically contain data that describes the attributes of each individual physical element (e.g., the walls, floors, ceilings, pipes, ducts, etc.) of the construction project. For instance, for an air duct designed to run across the first-floor ceiling of a building, a BIM file for this building may contain data describing how wide, how long, how high, and where, in relation to the other individual physical elements of the construction project, the duct is positioned.

There are many ways for BIM files to arrange and store data that describes the attributes of the individual physical elements of a construction project. In one specific example, BIM files may contain data that represents each individual physical component in the construction project (e.g., an air duct) as a mesh of geometric triangles such that when the geometric triangles are visually stitched together by BIM viewer software, the triangles form a mesh, which represents a scaled model of the physical component (e.g., the air duct). In this respect, the BIM file may contain data that represents each triangle of a given mesh as set of coordinates in three-space. For instance, for each triangle stored in the BIM file, the BIM file may contain data describing the coordinates of each vertex of the triangle (e.g., an x-coordinate, a y-coordinate, and a z-coordinate for the first vertex of the triangle; an x-coordinate, a y-coordinate, and a z-coordinate for the second vertex of the triangle; and an x-coordinate, a y-coordinate, and a z-coordinate for the third vertex of the triangle). A given mesh may be comprised of thousands, tens of thousands, or even hundreds of thousands of individual triangles, where each triangle may have a respective set of three vertices and corresponding sets of three-space coordinates for those vertices. However, other ways for a BIM file to contain data that represents each individual physical component in a construction project are possible as well.

In addition to data describing the individual triangles of a mesh, some BIM files may contain additional data that helps to summarize information relating to the various meshes. For instance, a BIM file may contain, for each mesh, data describing a "bounding box." Conceptually, a bounding box is an imaginary box surrounding the mesh on all sides, with the edges of this box being located at the outermost edges of the mesh. As such, the entire mesh fits inside of this bounding box with no part of the mesh protruding from the bounding box. In this way, the bounding box represents the maximum dimensions of the mesh in rectangular form. BIM viewer software may utilize bounding boxes stored in BIM files in various ways. For instance, it usually takes less storage space to store data describing a bounding box compared to data describing an entire mesh. This is due to the fact that a mesh may comprise of many thousands of triangles in order to accurately represent the mesh's surface, which in some cases is irregular (e.g., the curved surface of a pipe), whereas a bounding box can typically be represented by data describing just eight vertices of a rectangular box. Some BIM viewer software may be configured to operate in a mode designed to conserve processing power and/or storage space in which the BIM viewer software causes a computing device to render just bounding boxes as opposed to rendering the full meshes. By doing so, the BIM viewer software can visually communicate a "low resolution" version of the construction project. Other ways of utilizing bounding boxes, and other ways of containing additional data to help summarize information relating to the various meshes, are possible as well.

BIM files may contain additional data as well, including data describing other attributes of the individual physical elements of the construction project that may or may not be related to the element's specific position in three space. By way of example, this data may include data describing what system or sub-system the component is associated with (e.g., structural, plumbing, HVAC, electrical, etc.), data describing what material or materials the individual physical element is made of; what manufacturer the element comes from; what stage of manufacture the element is in; where the element currently resides (e.g., data indicating that the element is on a truck for delivery to the construction site, and/or once delivered, data indicating where at the construction site the delivered element resides); and/or various identification numbers assigned to the element (e.g., a serial number, part number, model number, tracking number, etc.), as well as others.

Together, these other attributes are generally referred to as metadata. BIM viewer software may utilize this metadata in various ways. For instance, some BIM viewer software may be configured to present different views based on metadata (e.g., displaying all meshes that represent HVAC components but hiding all meshes that represent plumbing components; and/or displaying meshes representing metal components in a certain color and displaying meshes representing wood components in another color, etc.). Alternatively or additionally, BIM viewers can display certain subsets of the metadata based on user input. For example, a user may provide a user input to the BIM viewer software though a click or tap on a GUI portion displaying a given mesh, and in response, the BIM viewer software may cause a GUI to display some or all of the attributes of the physical element represented by the given mesh. Other examples are possible as well.

As mentioned, BIM viewer software is generally deployed on client stations, such as client stations 112 of FIG. 1 (which, as described above, can generally take the form of a desktop computer, a laptop, a tablet, or the like). As such, construction professionals can utilize BIM viewer software during all phases of the construction project and can access a BIM file for a particular construction project in an office setting as well as on the construction site. Accordingly, BIM viewer software assists construction professionals with, among other things, the design and construction of the project and/or to identify issues that may arise during such construction.

### IV. EXAMPLE OPERATIONS

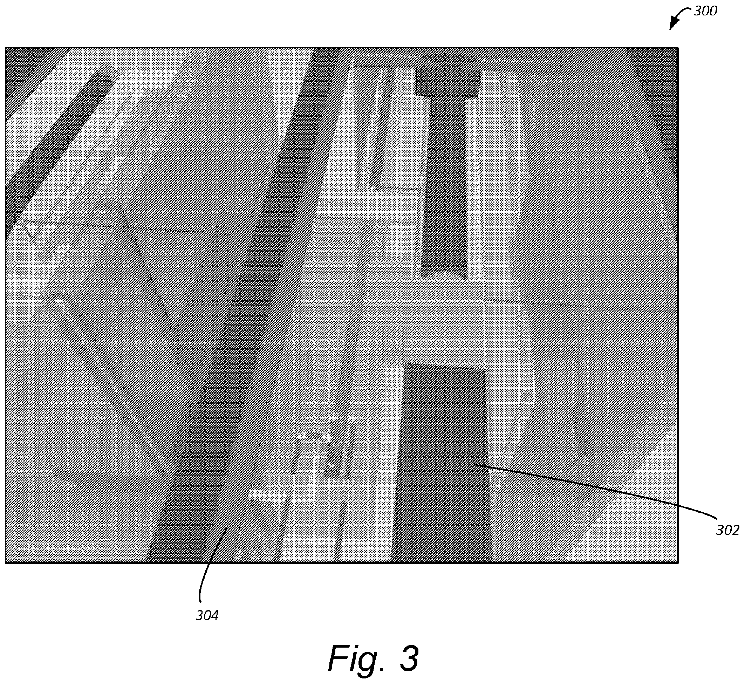

As noted, BIM viewer software operates to render a three-dimensional BIM view such that it presents a three-dimensional view of a construction project from a particular perspective. To illustrate one example of a rendered three-dimensional BIM view, FIG. 3 depicts an example snapshot 300 of a GUI, which includes a three-dimensional view of a construction project rendered at a particular perspective. Snapshot 300 may be generated by, for instance, a software tool running on a client station, such as one of client stations 112 (FIG. 1), accessing a BIM file, and then rendering a three-dimensional view of the construction project based on that BIM file and presenting it via a display interface of that client station. Alternatively, a back-end platform, such as back-end platform 102 (FIG. 1) may access a BIM file and may generate a set of instructions for rendering a three-dimensional view of the construction project based on that BIM file. Back-end platform 102 may then send these instructions to one of client stations 112, which in turn may present a three-dimensional view of the construction project via a display interface of that client station based on these instructions. Still other arrangements are possible.

As depicted, snapshot 300 includes a three-dimensional view of a construction project from a particular perspective. The three-dimensional view depicted in FIG. 3 includes a number of meshes that represent individual physical components of the construction project, such as floors, walls, pipes, ducts, etc. In particular, depicted in FIG. 3 is, among others, a mesh 302, which represents an air duct, and a mesh 304, which represents a support beam. Of course, in other examples, other meshes are possible as are other layouts and designs of construction projects.

As a general matter, a perspective from which the BIM viewer renders a three-dimensional BIM view, generally has four components: (1) an X-component, which reflects the position of the perspective along a lateral x-axis of the scaled model; (2) a Y-component, which reflects the position of the perspective along a lateral y-axis of the scaled model (where the lateral y-axis is perpendicular to the lateral x-axis); (3) a Z-component, which reflects the position of the perspective along a vertical z-axis of the scaled model (where the vertical z-axis is perpendicular to both the lateral x-axis and the lateral y-axis); and (4) an orientation, which reflects the direction of the perspective (where the "orientation" component is sometimes connotatively referred to as a "camera angle.").

The orientation component of the perspective can be broken down into two subcomponents: (i) a lateral angle, which reflects the direction of the perspective within a lateral plane; and (ii) a vertical angle, which reflects the direction of the perspective within a vertical plane. For example, an orientation with a lateral angle of 0° may look straight "North;" an orientation with a lateral angle of 90° may look straight "East;" an orientation with a lateral angle of 180° may look straight "South;" and an orientation with a lateral angle of 270° may look straight "West," although any angle from 0° to 360° is possible. Moreover, an orientation with a vertical angle of 0° may look straight up, an orientation with a lateral angle of 90° may look straight level with the ground, and an orientation with a lateral angle of 180° may look straight down, although any angle from 0° to 180° is possible. Although the cardinal directions "North," "East," "South," and "West" are used here to help conceptualize the lateral plane, it should be understood that in practice, an orientation with a lateral angle of 0° may not necessarily reflect a view that looks into the Cardinal direction North.

A client station presenting snapshot 300 may be configured to adjust the perspective at which the three-dimensional view is presented in response to, for instance, receiving user inputs at the client station. In some configurations, a client station may do this in various ways. As one possibility, the client station may reposition the perspective either forward or backward along an x-axis of the model in response to receiving a first type of user input via a peripheral, such as pressing the up arrow or down arrow on a keyboard or a click and drag with a mouse. The client station may reposition the perspective laterally along a y-axis of the model in response to receiving a second type of user input via a peripheral, such as pressing the left arrow or right arrow on a keyboard or a different type of click and drag with a mouse. The client station may reposition the perspective either up or down along a z-axis of the model in response to receiving a third type of user input via a peripheral, such as pressing a combination of keys on a keyboard (e.g., the Control key and the up arrow, or the Control key and the down arrow) or yet a different type of click and drag with a mouse. The client station may reposition the orientation of the perspective in response to receiving a fourth type of user input via a peripheral, such as pressing a combination of keys on a keyboard (e.g., the Alt key and the up arrow, or the Control key and the down arrow) or yet a different type of click and drag with a mouse.

As another possibility, the computing device may reposition the perspective simultaneously along a combination of one or more of the x-axis, the y-axis, and the z-axis of the model in response to receiving a first type of user input at a touch-screen of the computing device, such as a touch and drag gesture made with one finger (sometimes connotatively referred to as a "swipe"). For instance, in response to a touch and drag, the computing device may reposition the perspective a threshold amount in the direction of the perspective's orientation. The computing device may reposition the orientation of the perspective in response to receiving a second type of user input at a touch-screen of the computing device, such as a touch and drag gesture made with two fingers. However, other examples of adjusting the perspective at which the three-dimensional view is presented are possible as well.

These configurations, however, suffer from several drawbacks. For instance, in such configurations the computing device may only reposition the perspective so long as the user input is ongoing. For instance, in embodiments in which the computing device repositions the perspective in response to receiving a touch and drag user input, the computing device may only reposition the perspective during the drag portion of the user input. As screen real estate tends to be limited, the user may have to engage in repeated user inputs (e.g., repeated swipes) in order to reposition the perspective a relatively long distance, which tends to be more prone to user error and may thus result in a poor user experience. Additionally, in such configurations the computing device may only reposition the perspective in the direction of the perspective's orientation. Thus, repositioning the perspective in a direction other than the direction of the current perspective (e.g., repositioning directly along the z-axis only (i.e., straight up, vertically) or repositioning directly along one of the lateral axes only may require multiple user inputs (e.g., a first user input to re-orient the perspective in the desired direction, a second user input to reposition the perspective, and a third user input to re-orient the perspective back to a desired perspective). The number of user inputs required to reposition the perspective in the desired manner and to a desired location may be unexpectedly high and may thus too result in a poor user experience.

To address these problems (among others), disclosed herein is software technology that facilitates improved navigation of a three-dimensional BIM view. In one aspect, disclosed herein is a BIM viewer tool may facilitate navigation of the three-dimensional BIM view by adjusting the perspective along either or both of the lateral axes. In another aspect, the disclosed BIM viewer tool may facilitate navigation of the three-dimensional BIM view by adjusting the perspective directly along the vertical axis. And in yet another aspect, the disclosed BIM viewer tool may facilitate navigation of the three-dimensional BIM view by adjusting the orientation of the perspective along the two lateral axes and the vertical axis. To facilitate these types of navigation, the BIM viewer tool may generate a GUI that presents the three-dimensional BIM view as well as one or more navigational controls overlaid on the three-dimensional BIM view. The BIM viewer tool may also be configured to receive a user input at the navigational controls (e.g., a touch, or a touch combined with a drag), and, based on a respective user input, change the position of the perspective from which the BIM viewer tool renders the three-dimensional BIM view.

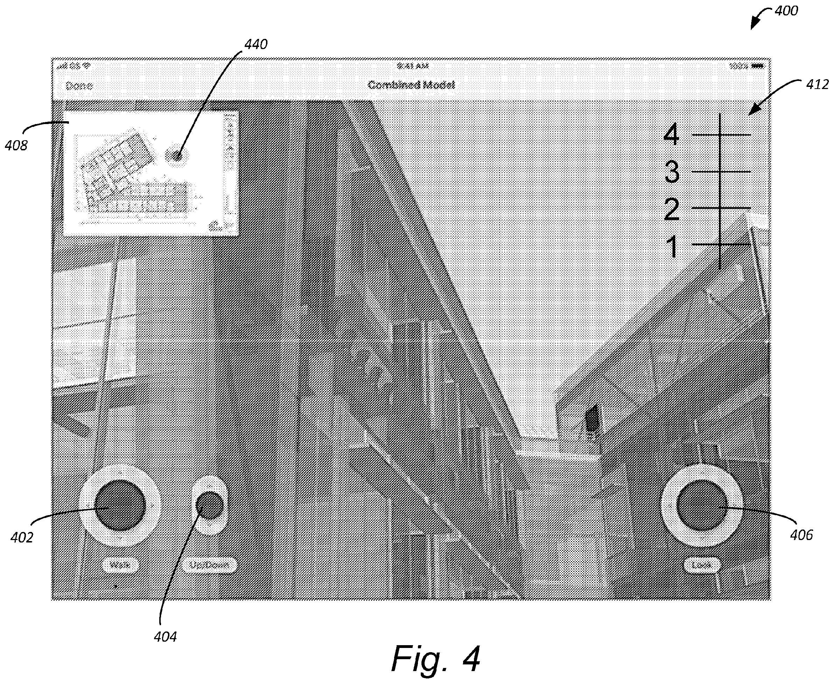

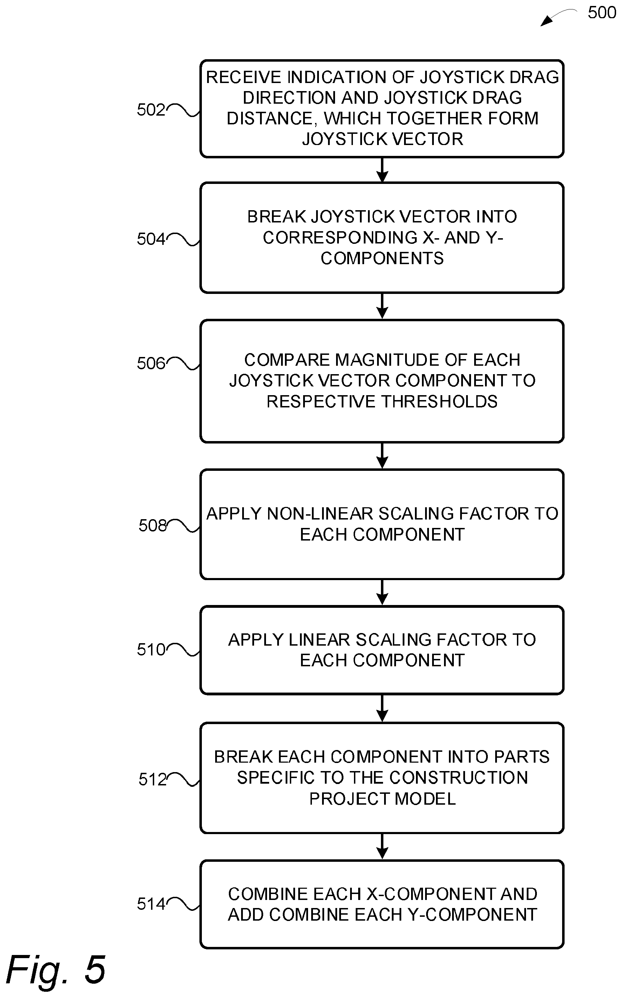

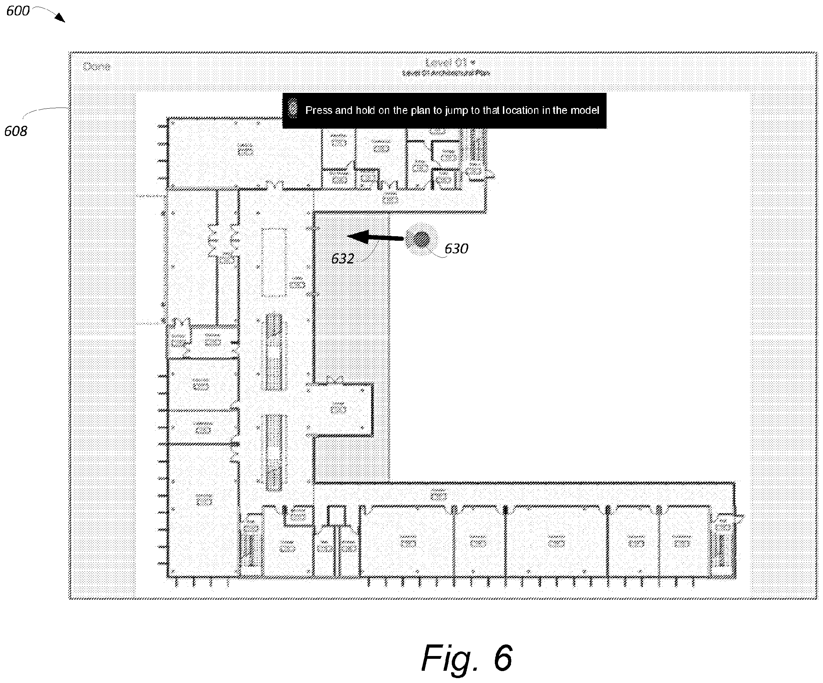

To illustrate the features and functionality of the disclosed BIM viewer tool on a more detailed level (but still by way of example), set forth below is a description that makes reference to FIGs. 4-6. FIGs. 4 and 6 generally depict screenshots from operational states of one or more embodiments of the disclosed BIM viewer tool, such as software developed by Procore Technologies, Inc., whereas FIG. 5 is a flow diagram 500 that depicts combinations of operations that may be performed by a computing device in accordance with the software technology disclosed herein.

It should be understood that each block in a flow diagram 500 may represent a module or portion of program code that includes instructions that are executable by a processor to implement specific logical functions or steps in a process. The program code may be stored on any type of computer-readable medium, such as non-transitory computer readable media (e.g., data storage 204 (FIG. 2)). In other cases, a block in a flow diagram may represent circuitry that is wired to perform specific logical functions or steps in a process. Moreover, the blocks shown in the flow diagram may be rearranged into different orders, combined into fewer blocks, separated into additional blocks, and/or removed, based upon the particular embodiment. The flow diagram may also be modified to include additional blocks that represent other functionality that is described expressly or implicitly elsewhere herein.

Further, as a general matter, when reference is made herein to "a BIM viewer tool" or "the BIM viewer tool" engaging in one or more operations, it should be understood that such operations may, in practice, be carried out by one or more computing devices executing one or more instances of the disclosed BIM viewer tool. In particular, it should be understood that such example operations may be carried out by a computing device, such as computing device 200 (FIG. 2), which as described above, may serve as one or more of client stations 112 (FIG. 1) and/or back-end platform 102 (FIG. 1). In this respect, it should be further understood that, depending on the implementation, the operations discussed herein below may be carried out entirely by a single computing device, such as one or more of client stations 112 or by back-end platform 102, or may be carried out by a combination of computing devices, with some operations being carried out by back-end platform 102 (such as computational processes and data-access operations) and other operations being carried out by one or more of client stations 112 (such as display operations and operations that receive user inputs). However, other arrangements are possible as well.

In accordance with one example of the disclosed BIM viewer tool, FIG. 4 depicts a snapshot 400 of a GUI, which includes a three-dimensional BIM view of a construction project rendered at a particular perspective. Snapshot 400 may be generated by, for instance, the disclosed BIM viewer tool running on a client station, such as one of client stations 112 (FIG. 1), accessing a BIM file, and then rendering a three-dimensional view of the construction project based on that BIM file and presenting it via a display interface of that client station. Alternatively, a back-end platform, such as back-end platform 102 (FIG. 1) may access a BIM file and may generate a set of instructions for rendering a three-dimensional view of the construction project based on that BIM file. Back-end platform 102 may then send these instructions to one of client stations 112, which in turn may present a three-dimensional view of the construction project it via a display interface of that client station based on these instructions. Still other arrangements are possible.

As depicted, the GUI presented in snapshot 400 may include various navigational controls overlaid on the three-dimensional BIM view, examples of which may include a "Walk" navigational control 402, an "Up/Down" navigational control 404, a "Look" navigational control 406, an 2D inset control 408, and an elevation control 412. Set forth below is a description of the operation of each individual navigational control. It should be understood that although the description herein makes reference to a GUI that includes each of these example navigational controls (e.g., the GUI depicted in snapshot 400), other examples of GUIs are possible that include fewer than these navigational controls, with any combination being possible. Further, some implementations of the disclosed BIM viewer tool may provide the option to enable or disable any one or more of the navigational controls and may provide the option to make one or more of the navigational controls visible or invisible on the GUI.

With respect to the Walk navigational control 402, the BIM viewer tool may be generally configured to detect a user input received via the Walk navigational control 402 and responsively change the position of the perspective along one or more of the two lateral axes. As depicted, the Walk navigational control 402 may take the form of a joystick that a user can manipulate by touching and dragging in any 360° direction. In some implementations, when a user touches and drags the joystick in a particular direction, the BIM viewer tool receives an indication of the direction in which the user dragged the joystick and an indication of how far from the origin the user dragged the joystick. Based on these two indications, the BIM viewer tool identifies a position along the lateral X-axis and the lateral Y-axis of the scaled model from which to render a new three-dimensional BIM view.

To illustrate how the disclosed software tool determines this new position, reference will be made to FIG. 5, which is a flow diagram depicting example process steps that may be carried out by a computing device executing the disclosed BIM viewer tool, according to one example implementation of the Walk navigational control 402. As mentioned, the example processing steps may be carried out either by a client station that is executing a front-end portion of the software tool, a back-end platform that is executing a front-end portion of the software tool, or some combination thereof.

First, at block 502, a user may provide a user input to the computing device via the GUI by touching and dragging the joystick of Walk navigational control 402 in a particular direction away from the center. Responsively, the computing device executing the disclosed software tool receives an indication of the direction the user dragged the joystick (e.g., on a scale from 0° to 360°) and an indication of the distance from the center to which the user dragged the joystick (e.g., on a percentage scale, where 0% corresponds to no movement from the center and 100% corresponds to the maximum allowable movement from the center). In one implementation, these indications together form what is referred to as a joystick vector. One example of a joystick vector is 50% at 45°, which, in this context, represents a user input that dragged the joystick halfway to the maximum distance in a direction that is halfway between the straight up direction and the straight right direction. Other examples of joystick vectors are possible as well.

Next at block 504, the computing device executing the disclosed software tool may break the joystick vector into corresponding X- and Y-components for further processing. For instance, using trigonometry with the above example joystick vector of 50% at 45°, the device executing the disclosed software tool breaks the example joystick vector of into an X-component by multiplying 50% by sine(45°), yielding an X-component of 35.4%, and a Y-component by multiplying 50% by cosine(45°), yielding a Y-component of 35.4%.

Next at block 506, the computing device executing the disclosed software tool may compare the magnitude of each component of the joystick vector to a threshold magnitude (e.g., 10%). If either the X-component or the Y-component component of the joystick vector is smaller than this threshold magnitude, then the computing device executing the disclosed software tool may ignore that respective component and may this not further process determination of a new perspective based on that component. In some implementations, this threshold is user adjustable.

Next at block 508, the computing device executing the disclosed software tool may apply a non-linear scaling factor to each individual component of the joystick vector. In one example, the computing device executing the disclosed software tool squares each component of the joystick vector, but in other examples, the computing device executing the disclosed software tool may cube each component or may apply some other non-linear scaling factor. By doing so, the computing device executing the disclosed software tool provides, what appears to the user as, a faster navigation through the three-dimensional BIM view when the user drags the joystick far from the center and a slower navigation through the three-dimensional BIM view when the user drags the joystick a short distance from the center. In some implementations, this non-linear scaling factor is user adjustable as well.

Next at block 510, the computing device executing the disclosed software tool may apply a linear scaling factor to each individual component of the joystick vector. In one example, the computing device executing the disclosed software tool multiplies each component by a scalar value (e.g., 5.0). By doing so, the computing device executing the disclosed software tool provides a particular sensitivity to the Walk navigational control 402. In this respect, a higher scalar value will cause the device executing the disclosed software tool to move the perspective by a larger step size for a given movement of the joystick, whereas a lower scalar value will cause the device executing the disclosed software tool to move the perspective by a smaller step size for a given movement of the joystick. In some implementations, this linear scale factor is user-adjustable.

Next at block 512, after applying the above-described rules, the computing device executing the disclosed software tool may break each remaining component of the joystick vector into component parts specific to the scaled model. For instance, using trigonometry, the computing device executing the disclosed software tool breaks the X-component of the joystick vector into an X-movement-component, which reflects how much of the X-component of the joystick vector translates to movement along the lateral X-axis of the scaled model; and a Y-movement-component, which reflects how much of the X-component of the joystick vector translates to movement along the lateral Y-axis of the scaled model. The computing device executing the disclosed software tool does the same computation for the Y-component of the joystick vector as well. Specifically, the computing device executing the disclosed software tool breaks the Y-component of the joystick vector into an X-movement-component, which reflects how much of the Y-component of the joystick vector translates to movement along the lateral X-axis of the scaled model; and a Y-movement-component, which reflects how much of the Y-component of the joystick vector translates to movement along the lateral Y-axis of the scaled model.

Breaking each remaining component of the joystick vector into component parts specific to the scaled model typically depends on the initial lateral angle of the orientation component. Thus, when breaking each remaining component of the joystick vector into component parts specific to the scaled model, the computing device typically accounts for this initial lateral angle and calculates the component parts based on this initial lateral angle. To illustrate an example of this, in the example starting with a joystick vector of 50% at 45°, assume an initial lateral angle of the perspective's orientation to be 80° (in other words, it can be said that the "camera angle" in this example is oriented toward the 'North-East," 80° off due-North and 10° off due-East), although other orientations are possible in other examples. Here, the X-movement-component of the X-component of the joystick can be calculated by multiplying the X-component of the joystick vector by cosine(80°), yielding 6.14, and the Y-movement-component of the of the X-component of the joystick vector can be calculated by multiplying the X-component of the joystick vector by sine(80°), yielding 34.81. Similarly, the X-movement-component of the Y-component of the joystick can be calculated by multiplying the Y-component of the joystick vector by sine(80°), yielding 34.81, and the Y-movement-component of the of the Y-component of the joystick vector can be calculated by multiplying the Y-component of the joystick vector by cosine(80°), yielding 6.14. In other examples with other initial lateral angles of the orientation component and other joystick vectors, other movement components are possible.

Next at block 514, the computing device executing the disclosed software tool may then combine the two X-movement-components (i.e., the X-movement-component calculated from the X-component of the joystick vector and the X-movement-component calculated from the Y-component of the joystick vector) to determine the total amount of movement of the perspective along the lateral X-axis of the scale model. Likewise, the computing device executing the disclosed software tool may combine the two Y-movement-components (i.e., the Y-movement-component calculated from the X-component of the joystick vector and the Y-movement-component calculated from the Y-component of the joystick vector) to determine the total amount of movement of the perspective along the lateral Y-axis of the scale model. The computing device may combine the respective components in either an additive manner, a subtractive manner, or a combination of the two, depending on the initial lateral angle of the orientation component and the angle of the joystick vector.

For instance, if the initial lateral angle of the orientation component added to the angle of the joystick vector (sometimes referred to as the "resultant angle") results in an angle between 0° and 90° inclusive, then the movement components are added together such that it results in a net movement in the positive X-direction and the Y-direction (or no movement along a particular axis if the resultant angle is exactly 0° or 90°). If the resultant angle is an angle greater than 90° and less than or equal to 180°, then the movement components are added together such that it results in a net movement in the positive X-direction but a net movement in the negative Y-direction (or no movement along the X-axis if the resultant angle is exactly 180°). If the resultant angle is an angle greater than 180° and less than or equal to 270°, then the movement components are added together such that it results in a net movement in the negative X-direction and the Y-direction (or no movement along the Y-axis if the resultant angle is exactly 270°). If the resultant angle is an angle greater than 270° and less than or equal to 360°, then the movement components are added together such that it results in a net movement in the negative X-direction but a net movement in the positive Y-direction (or no movement along the X-axis if the resultant angle is exactly 360° or 0°). Of course, other ways to combine the movement components are possible as well.

Once the computing device appropriately combines the respective movement components, the computing device may then reposition the perspective in accordance with the calculated total amount of movement along the lateral X-axis of the scale model and the total amount of movement along the lateral Y-axis of the scale model and thereby render a new three-dimensional BIM view at this new perspective. Once the computing device executing the disclosed software tool renders a new three-dimensional BIM view, the computing device executing the disclosed software tool may return to the beginning of the process, where, if the user is still providing input via the Walk navigational control 402 of the GUI (e.g., if the user is holding the joystick at a particular position, or if the user has dragged the joystick to a new position), the device executing the disclosed software tool may receive an indication of this user input and identify a new perspective in accordance with the procedure set forth above.

In an alternative implementation of the Walk navigation control 402, the device executing the disclosed software tool may be configured to detect a user input received via the Walk navigational control 402 and responsively change the position of the perspective along one or more of the two lateral axes and the vertical z-axis. Like the implementation above, when a user touches and drags the joystick in a particular direction, the device executing the disclosed software tool receives an indication of the direction in which the user dragged the joystick and an indication of how far from the origin the user dragged the joystick. But rather than adjusting the perspective within just the two lateral axes, the device executing the disclosed software tool adjusts the perspective such that it appears to the user that the three-dimensional BIM view is being navigated along the plane of the orientation of the current perspective. Thus, in one example, where the current orientation of the perspective is 45° along the vertical axis (i.e., a view about halfway between looking straight up and straight level with the ground), then movement of the perspective will be adjusted upwards along this 45° plane.

To facilitate this, this process steps carried out by the device executing the disclosed software tool are largely the same, except that that once the joystick vector is broken down into corresponding X- and Y-components, the Y-component is further broken down into a Z-component and a resulting Y component by using trigonometry.

For instance, using the example joystick vector described above, the Y-component of the joystick vector was determined to be 35.4%. In accordance with this alternative implementation and using an example orientation angle along the vertical axis of 45°, the device executing the disclosed software tool further breaks down this Y-component into a Z-component by multiplying 35.4% by sine(45°), yielding a Z-component of 25%, and a resulting-Y-component by multiplying 35.4% by cosine(45°), yielding a resulting-Y-component of 25%. The device executing the disclosed software tool adjusts the perspective along the z-axis of the scale model by this determined Z-component and continues to determine an adjusted position along the lateral axes of the scale model using the same process steps as described above, but in place of the Y-component, the device executing the disclosed software tool uses the resulting-Y-component determined in this step.

With respect to the Up/Down navigational control 304, the computing device executing the disclosed software tool may be further configured to detect a user input received via the Up/Down navigational control 404 and responsively change the position of the perspective of the three-dimensional BIM view along the vertical axis. As depicted in FIG. 3, the Up/Down navigational control 404 may represent a joystick that a user can manipulate by touching and dragging in either the up direction or the down direction. In some implementations, when a user touches and drags the joystick in a particular direction, the computing device executing the disclosed software tool receives an indication of the direction in which the user dragged the joystick and an indication of how far from the origin the user dragged the joystick. Based on these two indications, the computing device executing the disclosed software tool identifies a new position along the vertical axis of the scaled model from which to render a new three-dimensional BIM view.

The computing device executing the disclosed software tool may determine a new position along the vertical axis of the scaled model based on a user input received via the Up/Down navigational control 404 in largely the same way as set forth above, but because the Up/Down movement occurs in only one direction, the device executing the disclosed software tool may not break the joystick vector into components. For instance, according to one example implementation of the Up/Down navigational control 404, the device executing the disclosed software tool may engage in the following processing steps in response to receiving a user input via the Up/Down navigational control 404.

First, as mentioned, a user may provide an input via the GUI by touching and dragging the joystick of Up/Down navigational control 404 in a particular direction away from the center. Responsively, the computing device executing the disclosed software tool receives an indication of the direction the user dragged the joystick (e.g., the up direction or the down direction) and an indication of the magnitude of the joystick vector (e.g., the distance from the center to which the user dragged the joystick, which may, for example, take the form of a number on a percentage scale, where 0% corresponds to no movement from the center and 100% corresponds to the maximum allowable movement from the center). These indications together form what was referred to as a joystick vector. Again, one example of a joystick vector is 25% in the Up direction, which in this context represents a user input that dragged the joystick one-quarter of the maximum distance in the Up direction. Other examples are possible as well.

Second, the computing device executing the disclosed software tool may compare the magnitude of the joystick vector to a threshold magnitude (e.g., 10%). If the magnitude of the joystick vector is smaller than this threshold magnitude, then the device executing the disclosed software tool ignores the user input received via the Up/Down navigational control 404 and does not further process determination of a new perspective based on that user input. In some examples, this threshold is user adjustable.

Third, the computing device executing the disclosed software tool may apply a non-linear scaling factor to the joystick vector. In one example, the software tool squares the magnitude of the joystick vector, but in other examples, the device executing the disclosed software tool may cube the magnitude or apply some other non-linear scaling factor. By doing so, the computing device executing the disclosed software tool provides, what appears to the user as, a faster navigation through the three-dimensional BIM view when the user drags the joystick farther from the center and a slower navigation through the three-dimensional BIM view when the user drags the joystick a shorter distance from the center. In some examples, this non-linear scaling factor is user adjustable.

Fourth, the computing device executing the disclosed software tool may apply a linear scaling factor to the joystick vector. In one example, the device executing the disclosed software tool multiplies the magnitude of the joystick vector by a scalar value (e.g., 5.0). By doing so, the device executing the disclosed software tool provides a particular sensitivity to the Up/Down navigational control 404. In this respect, a higher scalar value will cause the software tool to move the perspective by a larger step size for a given movement of the joystick, whereas a lower scalar value will cause the software tool to move the perspective by a smaller step size for a given movement of the joystick. In some examples, this linear scale factor is user-adjustable.

Fifth, after applying the above described rules, the computing device executing the disclosed software tool may then move the perspective a particular distance either up or down the vertical axis of the scaled model (depending on whether the user dragged the joystick in either the Up or the Down direction) based on the scaled joystick vector. The computing device executing the disclosed software tool may render a new three-dimensional BIM view from this new perspective. Once the device executing the disclosed software tool renders a new three-dimensional BIM view, the software tool returns to the beginning of the process, where, if the user is still providing a user input to the Up/Down navigational control 404 via the GUI (e.g., if the user is holding the joystick at a particular position, or if the user has dragged the joystick to a new position), the computing device executing the disclosed software tool receives an indication of this user input and identifies a new perspective in accordance with the procedure set forth above. The computing device executing the disclosed software tool may determine a new position along the vertical axis of the scaled model based on a user input received via the Up/Down navigational control 404 in other ways as well.

With respect to the Look navigational control 406, the device executing the disclosed software tool may be further configured to detect a user input received via the Look navigational control 406 and responsively change the orientation of the perspective. As depicted in FIG. 4, the Look navigational control 306 may represent a joystick that a user can manipulate by touching and dragging in any 360° direction. In some implementations, when a user touches and drags the joystick in a particular direction, the device executing the disclosed software tool receives an indication of the direction in which the user dragged the joystick and an indication of how far from the origin the user dragged the joystick. Based on these two indications, the device executing the disclosed software tool identifies an angle along which to rotate the orientation of the three-dimensional BIM view and a speed at which to apply this rotation. For instance, according to one example implementation of the Look navigational control 406, the device executing the disclosed software tool may engage in the following processing steps in response to receiving a user input via the Look navigational control 406.

First, as mentioned, a user may provide an input via the GUI by touching and dragging the joystick of Look navigational control 406 in a particular direction away from the center. Responsively, the computing device executing the disclosed software tool receives an indication of the direction the user dragged the joystick (e.g., on a scale from 0° to 360°) and an indication of the distance from the center to which the user dragged the joystick (e.g., on a percentage scale, where 0% corresponds to no movement from the center and 100% corresponds to the maximum allowable movement from the center). In one implementation, these indications together form what is referred to as a joystick vector. One example of a joystick vector is 75% at 315°, which in this context represents a user input that dragged the joystick three-quarters to the maximum distance in a direction that is about halfway between the straight up direction and the straight left direction, but of course other examples are possible as well.

Second, the device executing the disclosed software tool may change the orientation of the perspective based on the joystick vector. For instance, the device executing the disclosed software tool rotates the orientation of the perspective along an angle that corresponds to the direction of the joystick vector. In the example given above, the joystick vector points in the 315° direction; thus, the device executing the disclosed software tool rotates the orientation of the current perspective along the 315° angle. The device executing the disclosed software tool rotates the orientation a particular number of degrees in the above-determined direction based on the magnitude of the joystick vector. In one example implementation, the device executing the disclosed software tool rotates the orientation of the current perspective by the same number of degrees as the magnitude. Thus, in the example given above, because the magnitude of the joystick vector is 75%, the device executing the disclosed software tool rotates the orientation of the current perspective by 75° in the 315° direction. In other implementations, however, the device executing the disclosed software tool scales the magnitude of the joystick vector and rotates the orientation of the current perspective by some scaled number of degrees. In any case, by rotating the orientation of the current perspective a particular number of degrees based on the magnitude of the joystick vector, the device executing the disclosed software tool provides, what appears to the user as, a faster rotation of the current perspective when the user drags the joystick far from the center and a slower rotation of the current perspective when the user drags the joystick a short distance from the center. In some examples, whether and to what extent the device executing the disclosed software tool applies a scale factor to the magnitude of this joystick vector is user adjustable.

With respect to the 2D inset control 408, the computing device executing the disclosed software tool may be further configured to detect a user input received via the 2D inset navigational control 308 and responsively change the position and the orientation of the perspective. As depicted in FIG. 4, the 2D inset control 408 includes a 2D image of the construction project at the elevation of the current three-dimensional BIM view, and an indicator 440 that represents the position and orientation of the current three-dimensional BIM view. For instance, as depicted in FIG. 4, the current perspective of the three-dimensional BIM view is somewhere within the first floor. Thus, the 2D inset navigational control 408 depicts a 2D view of the first floor. And the indicator 440 depicts the position of the perspective with respect to the scaled model and the orientation of the perspective. In some implementations, the computing device executing the disclosed software tool generates the 2D image from a blueprint file provided to or otherwise accessible by the BIM viewer software tool. In other cases, the device executing the disclosed software tool generates the 2D image based on the BIM file or BIM files from which the current three-dimensional BIM view is generated.

In any case, when a user provides a user input (such as a touch or tap) within the 2D inset navigational control 408 and drags in a particular direction, the computing device executing the disclosed software tool may receive an indication of the position at which the user touched as well as the direction the user dragged. Based on these two indications, the computing device executing the disclosed software tool may identify a position along the lateral X-axis and the lateral Y-axis of the scaled model and an orientation at which to render a new three-dimensional BIM view.

To help illustrate this process, FIG. 6 depicts an enlarged view of another example 2D inset navigational control 600, which includes 2D image 608. In accordance with one example implementation, assume a user touched the 2D inset navigational control 600 at position 630 and dragged in a direction represented by arrow 632. Responsively, the computing device executing the disclosed software tool may receive an indication of the position of this touch and the direction of the drag. The computing device executing the disclosed software tool may then translate the position of the touch to an X coordinate positioned along the lateral X-axis of the scaled model and a Y-coordinate positioned along the lateral Y-axis of the scaled model. Further, the computing device executing the disclosed software tool may translate the direction of the drag to a particular orientation angle along the lateral axis. Subsequent to this, this, the computing device executing the disclosed software tool may render a new three-dimensional BIM view at a perspective defined by the determined X-coordinate and Y-coordinate, a predetermined Z coordinate, and the determined orientation angle along the lateral axis. In this implementation, the device executing the disclosed software tool may use a predetermined point along the vertical Z-axis at which to render the new three-dimensional BIM view. This predetermined point along the vertical Z-axis may, in some implementations, be user adjustable.

In one implementation, the computing device executing the disclosed software tool keeps the other aspect of the perspective the same as it was before the user provided a user input via the 2D inset navigation control 408, namely the vertical angle of the orientation of the perspective. But in alternate implementations, the device executing the disclosed software tool resets this aspect to a predetermined vertical angle setting, such as a vertical angle that is level with the ground (i.e., 90°).

In an alternate implementation, the device executing the disclosed software tool may change the position and orientation of the of the perspective after a user touches, hold the touch for a threshold period of time (e.g., 1.0 seconds), and then drag in a particular direction. By waiting for a threshold period of time before registering a touch as a request to change position and orientation, the device executing the disclosed software tool may reduce the likelihood of inadvertent perspective changes.

Referring back to FIG. 4 and with respect to the elevation control 412, the device executing the disclosed software tool may be further configured to detect a user input received via the elevation control 312 and responsively change the position of the perspective along the vertical Z-axis. As depicted in FIG. 4, the elevation control 412 includes four lines labeled "1," "2," "3," and "4," which, in this example, represent the four floors of the construction project (of course, in other examples, other numbers of floors are possible). In one implementation, the computing device executing the disclosed software tool may generate the elevation control 312 based on the BIM file or BIM files the software tool uses to generate the three-dimensional BIM view. In one example of this, the device executing the disclosed software tool may read the BIM file or BIM files, determine that the construction project includes a building with four floors, and responsively generate an elevation control with four lines, such as the elevation control 412 depicted in FIG. 4. In addition, in some implementations, the device executing the disclosed software tool may associate each line of elevation control 412 with a particular position on the vertical Z-axis, such that a three-dimensional BIM view rendered at that particular position on the vertical z-axis provides a suitable view of the corresponding floor of the construction project.

In operation, when the computing device receives a user input via the elevation control (such as a touch or tap on one of the lines in elevation control 412), the device executing the disclosed software tool may, in response, adjust the position of the perspective along the vertical Z-axis to a corresponding predetermined position. For instance, in the example depicted in FIG. 4, if a user taps on or near the line next to "3," the device executing the disclosed software tool receives an indication that the user has tapped on or near the line labelled "3" and responsively adjusts the perspective of the three-dimensional BIM view to the predetermined position along the vertical Z-axis that provides a suitable view of the third floor. In one implementation, the device executing the disclosed software tool keeps the other aspects of the perspective the same as they were before the user provided a user input via the elevation control 412, namely the position of the perspective along the lateral X and Y axes and the orientation of the perspective. But in other embodiments, the software tool resets one or more of these other components to predetermined settings. Other examples of responsively changing the position of the perspective along the vertical Z-axis are possible as well.

### V. CONCLUSION

Example embodiments of the disclosed innovations have been described above. Those skilled in the art will understand, however, that changes and modifications may be made to the embodiments described without departing from the true scope of the present invention, which will be defined by the claims.

For instance, those in the art will understand that the disclosed approach for workflows for navigating through three-dimensional BIM views may be implemented in other constructionrelated areas. The disclosed approaches for navigating through three-dimensional BIM views could be used in other contexts as well.

Further, to the extent that examples described herein involve operations performed or initiated by actors, such as "humans," "operators," "users" or other entities, this is for purposes of example and explanation only. The claims should not be construed as requiring action by such actors unless explicitly recited in the claim language.

## Claims

1. A computing system comprising:
at least one processor;
a non-transitory computer-readable medium; and
program instructions stored on the non-transitory computer-readable medium that are executable by the at least one processor to cause the computing system to:
render, via a graphical user interface, GUI:
a three-dimensional view of a construction project using a three-dimensional model file that defines a set of meshes, wherein the three-dimensional view of the construction project has a perspective from which the three-dimensional view is presented; and
a two-dimensional inset (408) within the three-dimensional view, the two-dimensional inset depicting a two-dimensional view of the construction project at an elevation of the three-dimensional view and an indicator (440) representing a position and orientation of the perspective from which the three-dimensional view is presented;
based on a particular user input received via the two-dimensional inset, receive a particular indication that includes (i) a location component, and (ii) a direction component; and
responsive to receiving the particular indication, reposition the perspective from which the three-dimensional view of the construction project is generated based on the location component and the direction component.

2. The computing system of claim 1, wherein the perspective is repositioned in at least one of the following ways: (a) along two lateral axes simultaneously based on the direction component, (b) along a vertical axis based on the direction component, and (c) such that an orientation of the perspective is repositioned based on the direction component.

3. The computing system of claim 1,
wherein the GUI includes a navigational control (412) comprising indications of levels of the construction project, and
wherein the computing system further comprises program instructions that are executable by the at least one processor to cause the computing system to:
based on a particular user input received via the navigational control, receive a particular indication that comprises a selection of a particular level of the construction project, and
responsive to receiving the particular indication, reposition the perspective from which the three-dimensional view of the construction project is generated such that an orientation of the perspective is repositioned along a vertical axis so as to provide a three-dimensional view of the construction project at the particular level.

4. The computing system of claim 1, wherein the user input comprises a touch and drag, wherein the location component of the particular indication is based on a position of the touch within the two-dimensional inset, and wherein the direction component of the particular indication is based on a direction of the drag within the two-dimensional inset.

5. The computing system of claim 4, wherein the program instructions are executable by the at least one processor to cause the computing system to:
translate the position of the touch to (i) an X coordinate in the three-dimensional model file and (ii) a Y coordinate in the three-dimensional model file; and
translate the direction of the drag to an orientation angle in the three-dimensional model file.

6. The computing system of claim 1, wherein the perspective is repositioned along a predetermined Z coordinate.

7. The computing system of claim 1, wherein the program instructions are executable by the at least one processor to cause the computing system to generate the two-dimensional view of the construction project from the three-dimensional model file.

8. A computer-implemented method comprising:
rendering, via a graphical user interface, GUI:
a three-dimensional view of a construction project using a three-dimensional model file that defines a set of meshes, wherein the three-dimensional view of the construction project has a perspective from which the three-dimensional view is presented; and
a two-dimensional inset (408) within the three-dimensional view, the two-dimensional inset depicting a two-dimensional view of the construction project at an elevation of the three-dimensional view and an indicator (440) representing a position and orientation of the perspective from which the three-dimensional view is presented;
based on a particular user input received via the two-dimensional inset, receiving a particular indication that includes (i) a location component, and (ii) a direction component; and
responsive to receiving the particular indication, repositioning the perspective from which the three-dimensional view of the construction project is generated based on the location component and the direction component.

9. The method of claim 8, wherein the perspective is repositioned in at least one of the following ways: (a) along two lateral axes simultaneously based on the direction component, (b) along a vertical axis based on the direction component, and (c) such that an orientation of the perspective is repositioned based on the direction component.

10. The method of claim 8, wherein the user input comprises a touch and drag, wherein the location component of the particular indication is based on a position of the touch within the two-dimensional inset, and wherein the direction component of the particular indication is based on a direction of the drag within the two-dimensional inset.

11. The method of claim 10, further comprising:
translating the position of the touch to (i) an X coordinate in the three-dimensional model file and (ii) a Y coordinate in the three-dimensional model file; and
translating the direction of the drag to an orientation angle in the three-dimensional model file.

12. The method of claim 8, wherein the perspective is repositioned along a predetermined Z coordinate.

13. The method of claim 8, wherein the GUI includes a navigational control (412) comprising indications of levels of the construction project, the method further comprising:
based on a particular user input received via the navigational control, receive a particular indication that comprises a selection of a particular level of the construction project, and
responsive to receiving the particular indication, reposition the perspective from which the three-dimensional view of the construction project is generated such that an orientation of the perspective is repositioned along a vertical axis so as to provide a three-dimensional view of the construction project at the particular level.

14. The method of claim 8, comprising generating the two-dimensional view of the construction project from the three-dimensional model file.

15. A computer program product comprising instructions which, when the program is executed by a computer, cause the computer to carry out the method of any of claims 8 to 14.

## Patentansprüche

1. Rechensystem, umfassend:
mindestens einen Prozessor;
ein nichtflüchtiges computerlesbares Medium; und
Programmanweisungen, die auf dem nichtflüchtigen computerlesbaren Medium gespeichert sind, die durch den mindestens einen Prozessor ausführbar sind, um das Rechensystem zu veranlassen zum:
Rendern, über eine grafische Benutzeroberfläche, GUI:
einer dreidimensionalen Ansicht eines Konstruktionsprojekts unter Verwendung einer dreidimensionalen Modelldatei, die einen Satz von Netzen definiert, wobei die dreidimensionale Ansicht des Konstruktionsprojekts eine Perspektive aufweist, von der die dreidimensionale Ansicht präsentiert wird; und
eines zweidimensionalen Nebenbildes (408) innerhalb der dreidimensionalen Ansicht, wobei das zweidimensionale Nebenbild eine zweidimensionale Ansicht des Konstruktionsprojekts bei einer Vorderansicht der dreidimensionalen Ansicht abbildet, und eines Indikators (440), der eine Position und Ausrichtung der Perspektive darstellt, von der die dreidimensionale Ansicht präsentiert wird;
basierend auf einer speziellen Benutzereingabe, die über das zweidimensionale Nebenbild empfangen wird, Empfangen einer speziellen Angabe, die (i) eine Standortkomponente und (ii) eine Richtungskomponente einschließt; und
als Reaktion auf das Empfangen der speziellen Angabe, Repositionieren der Perspektive, von der die dreidimensionale Ansicht des Konstruktionsprojekts erzeugt wird, basierend auf der Standortkomponente und der Richtungskomponente.

2. Rechensystem nach Anspruch 1, wobei die Perspektive in mindestens einer der folgenden Arten repositioniert wird: (a) entlang zweier seitlicher Achsen gleichzeitig basierend auf der Richtungskomponente, (b) entlang einer vertikalen Achse basierend auf der Richtungskomponente und (c) derart, dass eine Ausrichtung der Perspektive basierend auf der Richtungskomponente repositioniert wird.

3. Rechensystem nach Anspruch 1,
wobei die GUI eine Navigationssteuerung (412) einschließt, umfassend Angaben von Ebenen des Konstruktionsprojekts und
wobei das Rechensystem ferner Programmanweisungen umfasst, die durch den mindestens einen Prozessor ausführbar sind, um das Rechensystem zu veranlassen zum:
basierend auf einer speziellen Benutzereingabe, die über die Navigationssteuerung empfangen wird, Empfangen einer speziellen Angabe, die eine Auswahl einer speziellen Ebene des Konstruktionsprojekts umfasst, und
als Reaktion auf das Empfangen der speziellen Angabe, derartiges Repositionieren der Perspektive, von der die dreidimensionale Ansicht des Konstruktionsprojekts erzeugt wird, dass eine Ausrichtung der Perspektive entlang einer vertikalen Achse repositioniert wird, um eine dreidimensionale Ansicht des Konstruktionsprojekts auf der speziellen Ebene bereitzustellen.

4. Rechensystem nach Anspruch 1, wobei die Benutzereingabe eine Berührung und ein Ziehen umfasst, wobei die Standortkomponente der speziellen Angabe auf einer Position der Berührung innerhalb des zweidimensionalen Nebenbildes basiert und wobei die Richtungskomponente der speziellen Angabe auf einer Richtung des Ziehens innerhalb des zweidimensionalen Nebenbildes basiert.

5. Rechensystem nach Anspruch 4, wobei die Programmanweisungen durch den mindestens einen Prozessor ausführbar sind, um das Rechensystem zu veranlassen zum:
Übersetzen der Position der Berührung in (i) eine X-Koordinate in der dreidimensionalen Modelldatei und (ii) eine Y-Koordinate in der dreidimensionalen Modelldatei; und
Übersetzen der Richtung des Ziehens in einen Ausrichtungswinkel in der dreidimensionalen Modelldatei.

6. Rechensystem nach Anspruch 1, wobei die Perspektive entlang einer vorbestimmten Z-Koordinate repositioniert wird.

7. Rechensystem nach Anspruch 1, wobei die Programmanweisungen durch den mindestens einen Prozessor ausführbar sind, um das Rechensystem zu veranlassen, die zweidimensionale Ansicht des Konstruktionsprojekts aus der dreidimensionalen Modelldatei zu erzeugen.

8. Computerimplementiertes Verfahren, umfassend:
Rendern, über eine grafische Benutzeroberfläche, GUI:
einer dreidimensionalen Ansicht eines Konstruktionsprojekts unter Verwendung einer dreidimensionalen Modelldatei, die einen Satz von Netzen definiert, wobei die dreidimensionale Ansicht des Konstruktionsprojekts eine Perspektive aufweist, von der die dreidimensionale Ansicht präsentiert wird; und
eines zweidimensionalen Nebenbildes (408) innerhalb der dreidimensionalen Ansicht, wobei das zweidimensionale Nebenbild eine zweidimensionale Ansicht des Konstruktionsprojekts bei einer Vorderansicht der dreidimensionalen Ansicht abbildet, und eines Indikators (440), der eine Position und Ausrichtung der Perspektive darstellt, von der die dreidimensionale Ansicht präsentiert wird;
basierend auf einer speziellen Benutzereingabe, die über das zweidimensionale Nebenbild empfangen wird, Empfangen einer speziellen Angabe, die (i) eine Standortkomponente und (ii) eine Richtungskomponente einschließt; und
als Reaktion auf das Empfangen der speziellen Angabe, Repositionieren der Perspektive, von der die dreidimensionale Ansicht des Konstruktionsprojekts erzeugt wird, basierend auf der Standortkomponente und der Richtungskomponente.

9. Verfahren nach Anspruch 8, wobei die Perspektive in mindestens einer der folgenden Arten repositioniert wird: (a) entlang zweier seitlicher Achsen gleichzeitig basierend auf der Richtungskomponente, (b) entlang einer vertikalen Achse basierend auf der Richtungskomponente und (c) derart, dass eine Ausrichtung der Perspektive basierend auf der Richtungskomponente repositioniert wird.

10. Verfahren nach Anspruch 8, wobei die Benutzereingabe eine Berührung und ein Ziehen umfasst, wobei die Standortkomponente der speziellen Angabe auf einer Position der Berührung innerhalb des zweidimensionalen Nebenbildes basiert und wobei die Richtungskomponente der speziellen Angabe auf einer Richtung des Ziehens innerhalb des zweidimensionalen Nebenbildes basiert.

11. Verfahren nach Anspruch 10, ferner umfassend:
Übersetzen der Position der Berührung in (i) eine X-Koordinate in der dreidimensionalen Modelldatei und (ii) eine Y-Koordinate in der dreidimensionalen Modelldatei; und
Übersetzen der Richtung des Ziehens in einen Ausrichtungswinkel in der dreidimensionalen Modelldatei.

12. Verfahren nach Anspruch 8, wobei die Perspektive entlang einer vorbestimmten Z-Koordinate repositioniert wird.

13. Verfahren nach Anspruch 8, wobei die GUI eine Navigationssteuerung (412) einschließt, umfassend Angaben von Ebenen des Konstruktionsprojekts, das Verfahren ferner umfassend:
basierend auf einer speziellen Benutzereingabe, die über die Navigationssteuerung empfangen wird, Empfangen einer speziellen Angabe, die eine Auswahl einer speziellen Ebene des Konstruktionsprojekts umfasst, und
als Reaktion auf das Empfangen der speziellen Angabe, derartiges Repositionieren der Perspektive, von der die dreidimensionale Ansicht des Konstruktionsprojekts erzeugt wird, dass eine Ausrichtung der Perspektive entlang einer vertikalen Achse repositioniert wird, um eine dreidimensionale Ansicht des Konstruktionsprojekts auf der speziellen Ebene bereitzustellen.

14. Verfahren nach Anspruch 8, umfassend das Erzeugen der zweidimensionalen Ansicht des Konstruktionsprojekts aus der dreidimensionalen Modelldatei.

15. Computerprogrammprodukt, umfassend Anweisungen, die, wenn das Programm durch einen Computer ausgeführt wird, den Computer veranlassen, das Verfahren nach einem der Ansprüche 8 bis 14 vorzunehmen.

## Revendications

1. Système informatique comprenant :
au moins un processeur ;
un support non transitoire lisible par ordinateur ; et
des instructions de programme stockées sur le support non transitoire lisible par ordinateur qui sont exécutables par l'au moins un processeur pour amener le système informatique à :
restituer, par l'intermédiaire d'une interface utilisateur graphique, GUI :
une vue tridimensionnelle d'un projet de construction à l'aide d'un fichier de modèle tridimensionnel qui définit un ensemble de maillages, dans lequel la vue tridimensionnelle du projet de construction présente une perspective à partir de laquelle la vue tridimensionnelle est présentée ; et
un encart bidimensionnel (408) au sein de la vue tridimensionnelle, l'encart bidimensionnel illustrant une vue bidimensionnelle du projet de construction au niveau d'une élévation de la vue tridimensionnelle et un indicateur (440) représentant une position et une orientation de la perspective à partir de laquelle la vue tridimensionnelle est présentée ;
sur la base d'une entrée utilisateur particulière reçue par l'intermédiaire de l'encart bidimensionnel, recevoir une indication particulière qui comporte (i) une composante de localisation, et (ii) une composante de direction ; et
en réponse à la réception de l'indication particulière, repositionner la perspective à partir de laquelle la vue tridimensionnelle du projet de construction est générée sur la base de la composante de localisation et de la composante de direction.

2. Système informatique selon la revendication 1, dans lequel la perspective est repositionnée au moins de l'une des manières suivantes : (a) le long de deux axes latéraux simultanément sur la base de la composante de direction, (b) le long d'un axe vertical sur la base de la composante de direction, et (c) de telle sorte qu'une orientation de la perspective est repositionnée sur la base de la composante de direction.

3. Système informatique selon la revendication 1,
dans lequel la GUI comporte une commande de navigation (412) comprenant des indications de niveaux du projet de construction, et
dans lequel le système informatique comprend en outre des instructions de programme qui sont exécutables par l'au moins un processeur pour amener le système informatique à :
sur la base d'une entrée utilisateur particulière reçue par l'intermédiaire de la commande de navigation, recevoir une indication particulière qui comprend une sélection d'un niveau particulier du projet de construction, et
en réponse à la réception de l'indication particulière, repositionner la perspective à partir de laquelle la vue tridimensionnelle du projet de construction est générée de telle sorte qu'une orientation de la perspective est repositionnée le long d'un axe vertical de façon à fournir une vue tridimensionnelle du projet de construction au niveau particulier.

4. Système informatique selon la revendication 1, dans lequel l'entrée utilisateur comprend un toucher et un glissement, dans lequel la composante de localisation de l'indication particulière est basée sur une position du toucher dans l'encart bidimensionnel, et dans lequel la composante de direction de l'indication particulière est basée sur une direction du glissement dans l'encart bidimensionnel.

5. Système selon la revendication 4, dans lequel les instructions de programme sont exécutables par l'au moins un processeur pour amener le système informatique à :
traduire la position du toucher en (i) une coordonnée X dans le fichier de modèle tridimensionnel et (ii) une coordonnée Y dans le fichier de modèle tridimensionnel ; et
traduire la direction du glissement en un angle d'orientation dans le fichier de modèle tridimensionnel.

6. Système informatique selon la revendication 1, dans lequel la perspective est repositionnée le long d'une coordonnée Z prédéterminée.

7. Système informatique selon la revendication 1, dans lequel les instructions de programme sont exécutables par l'au moins un processeur pour amener le système informatique à générer la vue bidimensionnelle du projet de construction à partir du fichier de modèle tridimensionnel.

8. Procédé mis en oeuvre par ordinateur comprenant :
la restitution, par l'intermédiaire d'une interface utilisateur graphique, GUI :
une vue tridimensionnelle d'un projet de construction à l'aide d'un fichier de modèle tridimensionnel qui définit un ensemble de maillages, dans lequel la vue tridimensionnelle du projet de construction présente une perspective à partir de laquelle la vue tridimensionnelle est présentée ; et
un encadré bidimensionnel (408) au sein de la vue tridimensionnelle, l'encart bidimensionnel illustrant une vue bidimensionnelle du projet de construction au niveau d'une élévation de la vue tridimensionnelle et un indicateur (440) représentant une position et une orientation de la perspective à partir de laquelle la vue tridimensionnelle est présentée ;
sur la base d'une entrée utilisateur particulière reçue par l'intermédiaire de l'encart bidimensionnel, la réception d'une indication particulière qui comporte (i) une composante de localisation, et (ii) une composante de direction ; et
en réponse à la réception de l'indication particulière, le repositionnement de la perspective à partir de laquelle la vue tridimensionnelle du projet de construction est générée sur la base de la composante de localisation et de la composante de direction.

9. Procédé selon la revendication 8, dans lequel la perspective est repositionnée au moins de l'une des manières suivantes : (a) le long de deux axes latéraux simultanément sur la base de la composante de direction, (b) le long d'un axe vertical sur la base de la composante de direction, et (c) de telle sorte qu'une orientation de la perspective est repositionnée sur la base de la composante de direction.

10. Procédé selon la revendication 8, dans lequel l'entrée utilisateur comprend un toucher et un glissement, dans lequel la composante de localisation de l'indication particulière est basée sur une position du toucher dans l'encart bidimensionnel, et dans lequel la composante de direction de l'indication particulière est basée sur la direction du glissement dans l'encart bidimensionnel.

11. Procédé selon la revendication 10, comprenant en outre :
la traduction de la position du toucher en (i) une coordonnée X dans le fichier de modèle tridimensionnel et (ii) une coordonnée Y dans le fichier de modèle tridimensionnel ; et
la traduction de la direction du glissement en un angle d'orientation dans le fichier de modèle tridimensionnel.

12. Procédé selon la revendication 8, dans lequel la perspective est repositionnée le long d'une coordonnée Z prédéterminée.

13. Procédé selon la revendication 8, dans lequel la GUI comporte une commande de navigation (412) comprenant des indications de niveaux du projet de construction, le procédé comprenant en outre :
sur la base d'une entrée utilisateur particulière reçue par l'intermédiaire de la commande de navigation, recevoir une indication particulière qui comprend une sélection d'un niveau particulier du projet de construction, et
en réponse à la réception de l'indication particulière, repositionner la perspective à partir de laquelle la vue tridimensionnelle du projet de construction est générée de telle sorte qu'une orientation de la perspective est repositionnée le long d'un axe vertical de façon à fournir une vue tridimensionnelle du projet de construction au niveau particulier.

14. Procédé selon la revendication 8, comprenant la génération de la vue bidimensionnelle du projet de construction à partir du fichier de modèle tridimensionnel.

15. Produit programme d'ordinateur comprenant des instructions, qui, lorsque le programme est exécuté par un ordinateur, amènent l'ordinateur à réaliser le procédé selon l'une quelconque des revendications 8 à 14.
